# EUROPEAN PATENT APPLICATION

(11) **EP 0 592 725 A1**
(43) Date of publication of application: **20.04.1994**
(21) Application number: 92202871.7
(22) Date of filing: 18.09.1992
(51) Int. Cl.: H04J 3/06, H03K 5/19

(54) **Transfer method, frame information extraction circuit and clock pulse stream regenerator used therein**

(71) Applicant: ALCATEL BELL Naamloze Vennootschap, B-2018 Antwerpen 1 (BE); ALCATEL N.V., NL-2288 BH Rijswijk (NL)
(72) Inventor: Haspeslagh, Johan Joseph Gustaaf, B-3001 Heverlee (BE); Reusens, Peter Paul Frans, B-9270 Laarne (BE)

(57) **Abstract**

A method for transferring a clock pulse stream and frame information over a single interconnection cable, from a transmitter to a receiver (CKR, FRR) of a telecommunication system. The modulation comprises the omission at the frame information pulse rate of pulses from the clock pulse stream.

A frame information extraction circuit (CKR, FRR) which includes:
- means (CLR) to regenerate the clock pulse stream (R155M) from the received modulated clock pulse stream (I155M);
- means (FF1/2) to decrease the clock pulse rate and the modulated clock pulse rate by two, thereby respectively generating a modified clock pulse stream (R75M) and a modified modulated clock pulse stream (I75M, D75M); and
- sampling means (FF3) to sample the modified modulated clock pulse stream at the modified clock pulse rate, thereby generating an output pulse stream (QFF3) whose pulse transitions are indicative of the frame information.

A clock pulse stream regenerator (CLR) which includes a pulse recovering circuit (M5-7, L, C, M10/11) having two branches (M10/M5; M11/M6) each including the series connection of a current source (M10; M11) and a switch (M5; M6). The branches are connected to a common second current source (M7) and the switches are differentially controlled by the modulated clock pulse stream (+/-I155M). The junction points of the current source and the switch of each branch are interconnected by an L-C tank filter (L, C) and constitute differential outputs at which a regenerated clock pulse stream (R155M) without missing pulses is obtained.

## Description

The present invention relates to a method for transferring a clock pulse stream and frame information from a transmitter to a receiver of a telecommunication system.

In a telecommunication system a clock pulse stream and frame information pulse stream, having a lower pulse rate or frequency than the clock pulse stream but synchronized therewith, may have to be transferred from a transmitter to a receiver. When the transmission speed, i.e. the clock pulse rate, is sufficiently low, two separate wires or interconnection cables may be used: one cable carrying the clock pulse stream and the other cable carrying the frame information. However, when a very high transmission speed is required, as is for instance the case in the known SONET/SDH environment, the lengths of the interconnection cables become an important factor since any difference of these lengths may introduce a delay affecting the synchronization of the two pulse streams. Tuning these lengths is not easy since the cables are subjected to ageing and temperature changes.

A first object of the present invention is to provide a method for transferring both the clock pulse stream and the frame information from a transmitter to a receiver while maintaining them synchronized even when a very high transmission speed is required.

According to the present invention, this first object is achieved due to the fact that said frame information modulates said clock pulse stream at a frame information pulse rate lower than the pulse rate of said clock pulse stream, the modulation comprising the omission at said frame information pulse rate of pulses from said clock pulse stream.

In this way the clock pulse stream constitutes the carrier pulse stream for modulating the frame information and the synchronization between the clock pulses and the frame information is ensured. In fact, the frame information so transferred is slightly different from a generally known frame signal. Indeed, the invention is based on the insight that the most important parameter of such a frame signal is its pulse rate or frequency rather than the length of its pulses, this length being generally not relevant for further purposes, and that therefore only the pulse rate of the frame signal has to be transferred as frame information. In the present method this is done by omitting the transfer of a single pulse, e.g. a positive pulse, of the clock pulse stream at the frame information pulse rate which is also the frame signal pulse rate.

When the present method is used the receiver needs to be provided with a demodulator or frame information extraction circuit able to regenerate the modulating frame information from the received modulated clock pulse stream.

The design of such a frame information extraction circuit may for instance be based on a principle of data recovery which is already known in the art, e.g. from the article "Smart Optical Receiver With Automatic Decision Threshold Setting and Retiming Phase Alignment" by M. KAWAI et al, published in the "Journal of the Lightwave Technology", Vol. 7, N° 11, November 1989, page 1634. Therein a data pulse stream is regenerated by means of a data recovery circuit using an oversampling technique according to which the data pulse stream is sampled at a sampling rate which is twice the rate of the data pulse stream. By using the information provided by the sampling operation, it is possible to detect any state transition of the pulses of the data pulse stream. If this oversampling technique would be applied to the present modulated clock pulse stream any missing pulse thereof would be detected as the succession of three consecutive same states, e.g. 3 consecutive binary zeroes ("0-0-0").

However, in the above mentioned SONET/SDH environment the clock pulse rate or frequency is about 155 MHz whereby the double sampling rate or frequency to be used in the frame information extraction circuit needs to be equal to 310 MHz. Such a high sampling frequency is difficult to achieve with classical means. Furthermore, it is known from practice that a factor of 3 or even 4, i.e. sampling frequencies of 465 or even 620 MHz, is preferred over the above factor 2 (double sampling frequency) to realize a suitable detection of state transitions. The circuitry required in a frame information extraction circuit adapted to achieve such a high frequency or pulse rate is complex, sensitive and generally consumes a large amount of power.

A second object of the present invention is to provide a frame information extraction circuit based on the principle of the above known oversampling technique, but which does not require the use of circuitry operating at frequencies which are higher than the clock pulse rate or frequency whereby classical components may be used and the cost may be reduced, e.g. by reducing the power consumption.

According to the invention, this second object is achieved due to the fact that the present frame information extraction circuit includes:
- means to regenerate a clock pulse stream from a received modulated clock pulse stream which has the pulse rate of said clock pulse stream and which is modulated by frame information having a pulse rate lower than the clock pulse rate, the modulation comprising the omission at the frame information pulse rate of pulses from the clock pulse stream;
- means to decrease the pulse rate of said clock pulse stream and of said modulated clock pulse stream at least by two, thereby generating a modified clock pulse stream and a modified modulated clock pulse stream respectively; and
- sampling means to sample said modified modulated clock pulse stream at the pulse rate of said modified clock pulse stream, thereby generating an output pulse stream whose pulse transitions are indicative of said frame information.

In this way, the highest frequency or pulse rate used in the frame information extraction circuit is the clock pulse rate. As a result, even in the SONET/SDH telecommunication environment, classical components such as CMOS transistors may be used instead of, e.g., bipolar transistors used in the ECL logic and consuming more power.

It is to be noted that although it seems possible to extract the frame information from the modulated clock pulse stream simply by applying the latter, together with the regenerated clock pulse stream, to a logical gate, e.g. an exclusive-OR gate, this can only be achieved when the two pulse streams are exactly synchronized both in frequency and in phase. Indeed, any phase difference, e.g. jitter, between these two pulse streams leads to the generation of unwanted pulses at the output of the logical gate. It is obvious that such a perfect synchronization is very difficult to achieve in practice especially when the clock pulse rate is high. As a consequence, such a simple circuitry has to be rejected.

Another characteristic feature of the present frame information extraction circuit is that it further includes a delay means for delaying said output pulse stream, thereby providing a second output pulse stream which is supplied, together with the first mentioned output pulse stream, to a logical gate generating a frame signal carrying said frame information, the delay generated by said delay means corresponding to at least one pulse duration of said modified clock pulse stream.

More particularly, said logical gate is an exclusive-OR gate which generates a pulse of said frame signal at each occurrence of an omitted pulse of said modulated clock pulse stream.

In this way, the leading edges of the pulses of the generated frame signal correspond to the omitted pulses of the modulated clock pulse stream, whilst the lengths of these pulses is determined by the delay generated by the delay means, i.e. the delay separating the first and the second output pulse streams.

Also another characteristic feature of the present frame information extraction circuit is that it further includes signal reshaping means for reshaping said modified modulated clock pulse stream prior to applying said reshaped modified modulated clock pulse stream to said sampling means so that said reshaped modified modulated clock pulse stream is sampled at optimal positions of the pulses thereof, and that said sampling means includes a second flipflop having a data input to which said reshaped modified modulated clock pulse stream is applied, a clock input to which said modified clock pulse stream is applied, and a data output at which said output pulse stream is provided.

Such a signal reshaping means is already known as such in the art, e.g. from the published European Patent Application N° EP-0502260-A1, and includes a tapped delay line and means to select the middle point of the delay taps corresponding to a valid pulse value in order to generate a reshaped signal. Such means are inventively used in the present frame information extraction circuit for additionally allowing the sampling means to sample the modified modulated clock pulse stream by said modified clock pulse stream at optimal sampling positions.

The present invention also relates to a clock pulse stream regenerator.

Since in the above mentioned telecommunication system the incoming modulated clock pulse stream contains both the clock pulse stream and frame information, respectively as carrier and modulating signals, it is generally also important to regenerate, additionally to the frame information as mentioned above, the original clock pulse stream.

A third object of the present invention is to provide a clock pulse stream regenerator which is relatively simple and cheap.

According to the invention, this third object is achieved due to the fact that the clock pulse stream regenerator includes a pulse recovering circuit controlled by a modulated clock pulse stream obtained by modulating a clock pulse stream by frame information having a lower pulse rate than said clock pulse stream, the modulation comprising the omission at the frame information pulse rate of pulses from said clock pulse stream, that said pulse recovering circuit includes two branches each including the series connection of a first current source and a switch, the ends of said branches being respectively connected to a first supply terminal directly and to a second supply terminal via a common second current source, that said switches are differentially controlled by said modulated clock pulse stream, and that the junction points of said first current source and of said switch of each branch are interconnected by a tank filter constituted by the parallel connection of a capacitor and a self-inductance, said junction points constituting differential outputs of said pulse recovering circuit at which a regenerated clock pulse stream without missing pulses is obtained.

In more detail, the pulse recovering circuit operates as a "resonator" at the frequency or pulse rate of the modulated clock pulse stream which is equal to the frequency of the clock pulse stream to be regenerated. Owing to the L-C tank filter, the inertia of this pulse recovering circuit is such that a clock pulse is anyway provided at the output of the clock pulse stream regenerator even when a pulse is missing in the incoming modulated clock pulse stream. Furthermore, since the highest pulse rate used in the present clock pulse stream regenerator is the clock pulse rate, i.e. the clock frequency of 155 MHz in case of the above SONET/SDH environment, the present regenerator may be built up with only classical electronic components. The present clock pulse stream regenerator remains thus relatively simple and cheap.

Another characteristic feature of the present clock pulse stream regenerator is that the quality coefficient Q of said tank filter is relatively high.

Moreover, said switches are each constituted by a MOS transistor to the gate electrodes of which the differential modulated clock pulse stream is applied.

If the present clock pulse stream regenerator is used in the above frame information extraction circuit, the latter may extract the frame information from the modulated clock pulse stream by using the clock pulse stream regenerated by this clock pulse stream regenerator;

In this way, no additional signal, e.g. an external clock signal or a synchronization signal, is required.

The above mentioned and other objects and features of the invention will become more apparent and the invention itself will be best understood by referring to the following description of an embodiment taken in conjunction with the accompanying drawings wherein :
Fig. 1 shows a frame information extraction circuit CKR, FRR according to the invention;
Fig. 2 shows a clock pulse stream regenerator CLR also according to the invention and used in the frame information extraction circuit of Fig. 1; and
Figs. 3a to 3h represent different signals appearing in the frame information extraction circuit of Fig. 1 and in the clock pulse stream regenerator of Fig. 2.

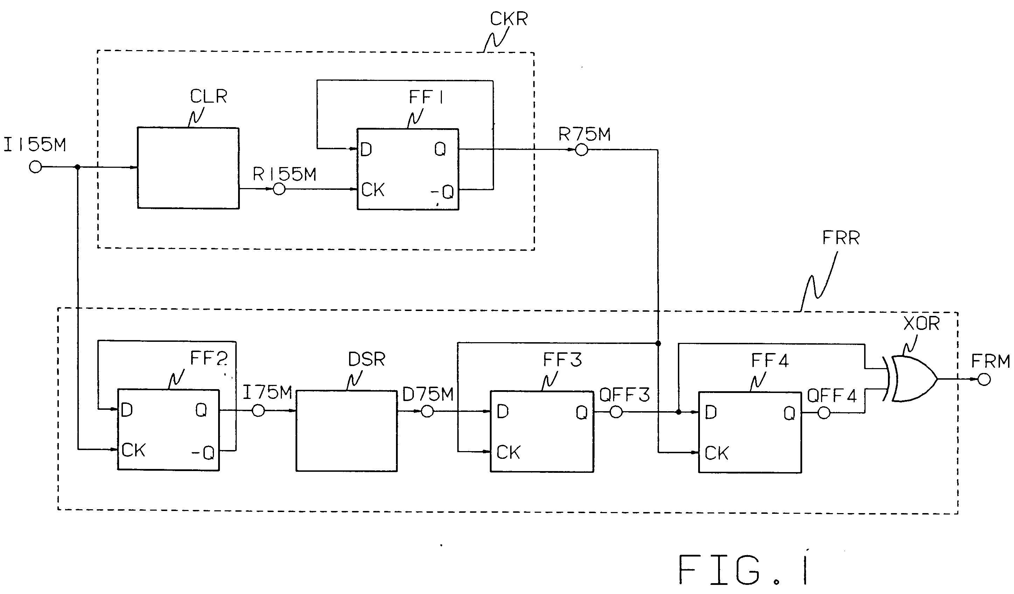

The frame information extraction circuit shown in Fig. 1 is used in a receiver which forms part of a digital telecommunication system and is coupled via an interconnection cable to a transmitter (not shown) wherein a clock signal or pulse stream is modulated by a frame signal by removing a single pulse from this clock signal at each occurrence of a pulse of the frame signal independently from the length or duration of this frame information pulse. As a result, the carrier of the modulated clock pulse stream I155M is almost the clock signal but with missing pulses occurring at the pulse rate of the modulating frame signal. The purpose of the frame information extraction circuit is to regenerate both the frame signal and the clock signal from this modulated clock signal or pulse stream I155M received at a like named input terminal from the transmitter and via the interconnection cable mentioned.

This frame information extraction circuit is more particularly used in a known telecommunication SONET/SDH environment where the frame signal and thus the frame information pulse stream has a pulse rate or frequency of 166 Hz, whilst the clock pulse stream has a pulse rate or frequency of 155 MHz.

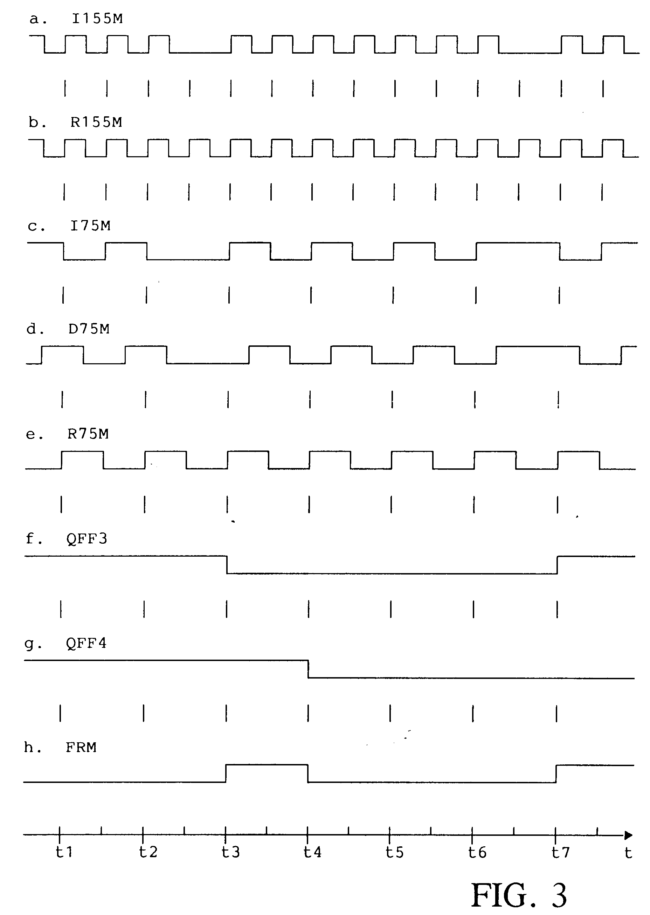

From the incoming modulated clock pulse stream I155M at 155 MHz, an example of which is shown in Fig. 3a, the frame information extraction circuit regenerates a clock signal R155M at 155 MHz as shown in Fig. 3b, a frame signal FRM at 166 Hz as shown in Fig. 3h as well as a modified clock signal R75M at half the clock frequency, i.e. at 77.5 MHz, as shown in Fig. 3e. To this end, the frame information extraction circuit shown in Fig. 1 includes a clock signal regenerator part CKR and a frame signal regenerator part FRR.

The clock signal regenerator part CKR comprises, between the input terminal I155M and a modified clock output terminal R75M, the series connection of a clock signal or clock pulse stream regenerator CLR and a frequency divider FF1. The purpose of CLR is to regenerate a clock signal R155M at 155 MHz corresponding to the frequency of the original clock signal or pulse stream, whilst the aim of FF1 is to divide by two the frequency of 155 MHz of the regenerated clock signal R155M and to provide the modified clock signal R75M at the frequency of 77.5 MHz. Indeed, as will become clear later the division by two, or more generally the fact of decreasing the frequency of the regenerated clock signal R155M and the modulated incoming signal I155M, allows the frame information extraction circuit to generate the frame information pulse stream FRM without operating at a frequency which is higher than that of the incoming modulated clock signal I155M, i.e. of the clock signal R155M.

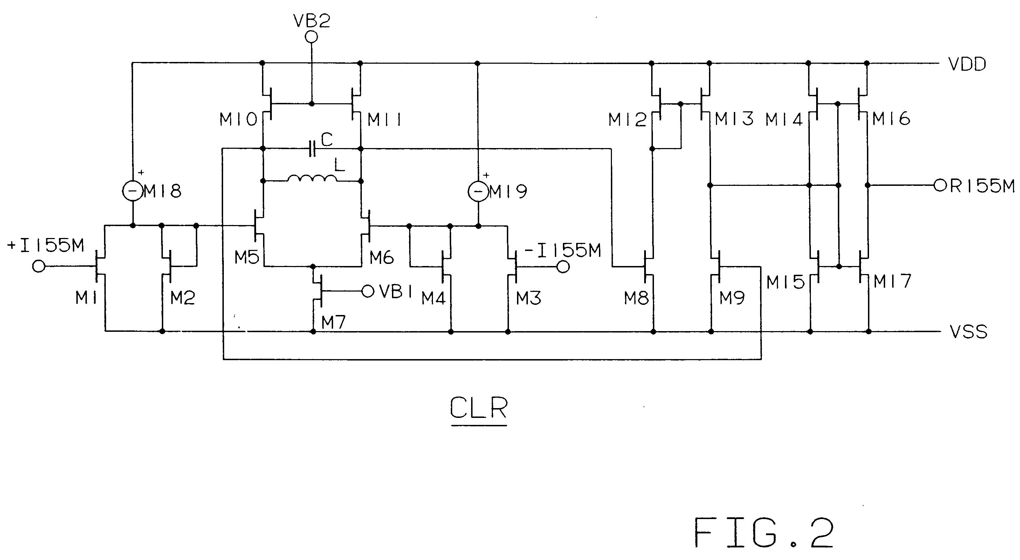

The clock pulse stream regenerator CLR is shown in more detail in Fig. 2. CLR has two input terminals +I155M and -I155M to which the incoming modulated clock signal I155M shown in Fig. 3a is differentially applied, and an output terminal R155M at which the like named regenerated clock pulse stream at 155 MHz and shown in Fig. 3b is provided. CLR includes, between supply terminals VSS and VDD, a pulse recovering circuit constituted by two branches each comprising the series connection of the main paths of two MOS transistors M5/M6 and M10/M11. The source electrodes of the transistors M5 and M6 are connected to the voltage supply terminal VSS via a common current source constituted by another MOS transistor M7 and the drain electrodes of the transistors M10 and M11 are connected in common to the voltage supply terminal VDD directly. The junction points of the transistors M5/M6 and M10/M11 are interconnected by an L-C tank circuit constituted by the parallel connection of a capacitor C and a self-inductance L. These junction points constitute the differential outputs of the pulse recovering circuit of which the differential inputs are constituted by the gate electrodes of the transistors M5 and M6. A reference bias voltage VB1 is applied via a like named terminal to the gate electrode of the transistor M7, whilst another reference bias voltage VB2 is applied via a like named terminal to the gate electrodes of both the transistors M10 and M11 which thereby operate as constant current sources.

The differential incoming modulated clock pulse stream is applied to the input terminals +I155M/-I155M which are connected to the gate electrodes of MOS transistors M1/M3 of distinct level shifters. These level shifters each respectively further includes a current source M18/M19 coupled in series with a diode-connected second MOS transistor M2/M4 between the voltage supply terminals VDD and VSS. The input transistor M1/M3 of each level shifter is coupled in parallel across the diode-connected transistor M2/M4 and its junction point with the current source M18/M19 is connected to the gate electrode of the transistor M5/M6 respectively of the pulse recovering circuit. In this way any voltage variation at the gate electrode of M1/M3, i.e. any variation of the differential modulated clock signal +I155M/-I155M, is amplified and transmitted to the pulse recovering circuit.

The transistors M5 and M6 then act as switches controlled by the outputs of the level shifters. Because M5 and M6 are complementarily and alternatively switched ON and OFF, an alternative current flows through the L-C tank circuit or filter. Indeed, when M5 is closed and M6 open, a current flows from VDD to VSS via M11, L-C and M5, whilst when M6 is closed and M5 open, an identical current flows via M10, L-C and M6, i.e. in the other direction through L-C.

The L-C tank circuit or filter has a high quality factor Q whereby the pulse recovering circuit operates as a "resonator" showing a certain inertia. As a result, a pulse is provided at the differential outputs of the pulse recovering circuit not only when such a pulse is present in the incoming modulated clock pulse stream +I155M/-I155M, but also when such a pulse is missing therein, i.e. at the occurrence of the modulating frame information. The differential signal at the outputs of the pulse recovering circuit is thus a regenerated clock signal.

This differential regenerated clock pulse stream is then applied to classical circuits including a differential-to-single-ended signal transformer and a signal amplifier and comprising the MOS transistors M8, M9, M12, M13, M14, M15, M16 and M17 interconnected as shown in Fig 2. These circuits are known in the art and will therefore not be described in more detail herein. They provide, at the output terminal R155M of CLR, a single ended clock pulse stream R155M of 155 MHz at a CMOS level.

Referring again to Fig. 1, the output terminal R155M of CLR is connected to the clock input CK of the frequency divider FF1 which is a D-flipflop having its data output terminal Q connected to the clock output terminal R75M. To divide by two the frequency of the regenerated clock signal at R155M, FF1 has its inverted-data output -Q connected to its data input D. The modified clock signal R75M shown in Fig. 3e is thereby provided at the like named clock output terminal.

The frame signal regenerator part FRR of the frame information extraction circuit has input terminals I155M and R75M and a frame output terminal FRM at which a like named regenerated frame signal or pulse stream shown in Fig. 3h is provided. FRR comprises between the input terminal I155M and the output terminal FRM the series connection of a second frequency divider FF2, a signal reshaping circuit DSR, a sampling circuit FF3, a delay circuit FF4 and an exclusive-OR logical gate XOR, FF3 and FF4 being controlled by the modified clock signal R75M.

The incoming modulated clock signal I155M shown in Fig. 3a is applied to the clock input CK of the frequency divider FF2 which is identical to and operates as the above described D-flipflop FF1. In more detail, FF2 has its inverted-data output -Q connected to its data input D, whilst its data output Q is connected to a terminal I75M where a like named modified modulated clock pulse stream is provided. This modified modulated clock pulse stream I75M is shown in Fig. 3c and corresponds to the incoming modulated clock pulse stream I155M but at half the frequency thereof, i.e. at 77.5 MHz.

The terminal I75M is connected to the signal reshaping circuit DSR which not only performs a reshaping of the modified modulated clock signal I75M but also shifts the latter in order to allow its future synchronization with the modified clock signal R75M. To this end DSR includes, between its input terminal I75M and its output terminal D75M on which a like named reshaped modified modulated clock signal is provided, a tapped delay line and an optimal-sampling-points search circuit. The incoming modified modulated clock signal I75M is delayed in the tapped delay line and the taps giving the optimal sampling points are chosen on the basis of a jitter analysis performed by the optimal-sampling-points search circuit. The jitter analysis is realized by observing the edges of the pulses of the signal I75M applied to the delay line. This is achieved by sampling all the delay taps and by comparing their values with the previous ones. Only the delay taps with constant stable values are candidate for the reshaped signal D75M. The middle point of the chosen delay taps is then selected and used for generating the reshaped modified modulated clock signal D75M. The update rate for the selection of delay taps has been chosen for convenience at a frequency of 166 Hz. At the output D75M of the reshaping circuit DSR, the reshaped modified modulated clock pulse stream D75M, which is almost the modified clock pulse stream R75M but with missing pulses, is such that valid points of its pulses always correspond to leading edges of the pulses of the signal or pulse stream R75M. This is shown in the Figs. 3d and 3e. In other words, the time position of the reshaped modulated clock signal D75M is such that the forthcoming sampling operations thereof will occur at the raising edges of the modified clock signal R75M, i.e. at the time moments t1, ..., t7 of Fig. 3. A signal reshaping circuit as DSR is already known in the art, e.g. from the above mentioned European Patent Application N° EP-0502260-A1, and will therefore neither be described nor shown in more detail here.

The reshaped modified modulated clock signal D75M is supplied to a data input D of the sampling circuit FF3 which is a D-flipflop to the clock input CK of which the modified clock signal R75M is applied. As a result, D75M is sampled by R75M thereby producing the output pulse stream or signal QFF3 on a like named output terminal to which the data output Q of FF3 is connected.

Each pulse transition of the output signal QFF3, shown in Fig. 3f, corresponds to a missing pulse of the modulated clock pulse stream I155M shown in Fig. 3a. This output signal QFF3 thus contains the above frame information which may further be used to generate the frame signal FRM as shown in Fig. 3h.

To this end, the output signal QFF3 is applied to a data input D of the delay circuit FF4 which is also a D-flipflop at the clock input CK of which the modified clock signal R75M is applied. An output signal or pulse stream QFF4 is provided at the data output Q of FF4 which is further connected to an output terminal QFF4. This output signal QFF4, shown in Fig. 3g, corresponds to the above output pulse stream QFF3 delayed by one sampling period, i.e. by one period of the modified clock signal R75M. It is to be noted that other delays could be generated by slightly modifying the present circuit, e.g. by changing the delay circuit FF4 or by dividing the frequencies of the signals I155M and/or R155M by a number different from two.

The output terminals QFF3 and QFF4 are connected to distinct inputs of the exclusive-OR gate XOR of which the output is connected to the frame output terminal FRM. As can be seen in the Figs. 3f, 3g and 3h the output signal FRM of XOR at the like named output terminal constitutes the expected regenerated frame signal FRM. The pulses of this frame signal FRM start at each occurrence of the above frame information indicated by a missing positive pulse of the incoming modulated clock pulse stream I155M and the lengths of the pulses of FRM correspond to delay separating QFF3 and QFF4.

While the principles of the invention have been described above in connection with specific apparatus, it is to be clearly understood that this description is made only by way of example and not as a limitation on the scope of the invention.

## Claims

1. Method for transferring a clock pulse stream and frame information from a transmitter to a receiver (CKR, FRR) of a telecommunication system, characterized in that said frame information modulates said clock pulse stream at a frame information pulse rate lower than the pulse rate of said clock pulse stream, the modulation comprising the omission at said frame information pulse rate of pulses from said clock pulse stream.

2. Frame information extraction circuit, characterized in that it includes:
- means (CLR) to regenerate a clock pulse stream (R155M) from a received modulated clock pulse stream (I155M) which has the pulse rate of said clock pulse stream and which is modulated by frame information having a pulse rate lower than the clock pulse rate, the modulation comprising the omission at the frame information pulse rate of pulses from the clock pulse stream;
- means (FF1/2) to decrease the pulse rate of said clock pulse stream and of said modulated clock pulse stream at least by two, thereby generating a modified clock pulse stream (R75M) and a modified modulated clock pulse stream (I75M, D75M) respectively; and
- sampling means (FF3) to sample said modified modulated clock pulse stream at the pulse rate of said modified clock pulse stream, thereby generating an output pulse stream (QFF3) whose pulse transitions are indicative of said frame information.

3. Frame information extraction circuit according to claim 2, characterized in that it further includes a delay means (FF4) for delaying said output pulse stream (QFF3), thereby providing a second output pulse stream (QFF4) which is supplied, together with the first mentioned output pulse stream, to a logical gate (XOR) generating a frame signal (FRM) carrying said frame information, the delay generated by said delay means corresponding to at least one pulse duration of said modified clock pulse stream (R75M).

4. Frame information extraction circuit according to claim 3, characterized in that said logical gate is an exclusive-OR gate (XOR) which generates a pulse of said frame signal (FRM) at each occurrence of an omitted pulse of said modulated clock pulse stream (I155M).

5. Frame information extraction circuit according to claim 3, characterized in that said delay means includes a flipflop (FF4) having a data input (D) to which said output pulse stream (QFF3) is applied, a clock input (CK) to which said modified clock pulse stream (R75M) is applied, and a data output (Q) at which said second output pulse stream (QFF4) is provided.

6. Frame information extraction circuit according to claim 2, characterized in that it further includes signal reshaping means (DSR) for reshaping said modified modulated clock pulse stream (I75M) prior to applying said reshaped modified modulated clock pulse stream (D75M) to said sampling means (FF3) so that said reshaped modified modulated clock pulse stream is sampled at optimal positions of the pulses thereof, and in that said sampling means includes a second flipflop (FF3) having a data input (D) to which said reshaped modified modulated clock pulse stream (D75M) is applied, a clock input (CK) to which said modified clock pulse stream (R75M) is applied, and a data output (Q) at which said output pulse stream (QFF3) is provided.

7. Frame information extraction circuit according to claim 2, characterized in that said pulse rate decreasing means each includes a third flipflop (FF1/2) having an inverted-data output (-Q) connected to its data input (D), thereby dividing by two the pulse rate of the pulse stream (R155M/I155M) applied at the clock input (CK) of said third flipflop.

8. Clock pulse stream regenerator, characterized in that it includes a pulse recovering circuit (M5-7, L, C, M10/11) controlled by a modulated clock pulse stream (I155M) obtained by modulating a clock pulse stream by frame information having a lower pulse rate than said clock pulse stream, the modulation comprising the omission at the frame information pulse rate of pulses from said clock pulse stream, in that said pulse recovering circuit includes two branches (M10, M5; M11, M6) each including the series connection of a first current source (M10; M11) and a switch (M5; M6), the ends of said branches being respectively connected to a first supply terminal (VDD) directly and to a second supply terminal (VSS) via a common second current source (M7), in that said switches are differentially controlled by said modulated clock pulse stream (+/-I155M), and in that the junction points of said first current source and of said switch of each branch are interconnected by a tank filter (L, C) constituted by the parallel connection of a capacitor (C) and a self-inductance (L), said junction points constituting differential outputs of said pulse recovering circuit at which a regenerated clock pulse stream (R155M) without missing pulses is obtained.

9. Clock pulse stream regenerator according to claim 8, characterized in that the quality coefficient Q of said tank filter (L, C) is relatively high.

10. Clock pulse stream regenerator according to claim 8, characterized in that said switches are each constituted by a MOS transistor (M5/6) to the gate electrodes of which the differential modulated clock pulse stream (+/-I155M) is applied.

11. Clock pulse stream regenerator according to any of the claims 8 to 10, characterized in that it is used in the frame information extraction circuit of claims 2 to 7.
